Europäisches Patentamt

European Patent Office

Office européen des brevets

(19)

(11) **EP 0 731 566 B1**

(12) **EUROPÄISCHE PATENTSCHRIFT**

(45) Veröffentlichungstag und Bekanntmachung des Hinweises auf die Patenterteilung:
**29.05.2002 Patentblatt 2002/22**

(51) Int Cl.$^7$: **H03M 1/66**, H03M 3/02

(21) Anmeldenummer: **96102692.9**

(22) Anmeldetag: **22.02.1996**

(54) **Schaltungsanordnung zur Umsetzung eines 1-Bit-Digital-signals in ein Analogsignal**

Circuit arrangement for the conversion of a 1-bit digital signal into an analog signal

Arrangement de circuit pour la conversion d'un signal numérique avec un bit dans un signal analogique

(84) Benannte Vertragsstaaten:
**DE FR GB IT**

(30) Priorität: **02.03.1995 DE 19507311**

(43) Veröffentlichungstag der Anmeldung:
**11.09.1996 Patentblatt 1996/37**

(73) Patentinhaber: **Infineon Technologies AG**
**81669 München (DE)**

(72) Erfinder: **Hauptmann, Jörg, Dipl.-Ing.**
**9500 Villach (CH)**

(74) Vertreter: **Barth, Stephan Manuel, Dr. et al**
**Reinhard-Skuhra-Weise & Partner Gbr,**
**Patentanwälte**
**Friedrichstrasse 31**
**80801 München (DE)**

(56) Entgegenhaltungen:
**US-A- 5 323 158**

• **MATSUYA Y ET AL: "A 17-BIT IVERSAMPLING D-TO-A CONVERSION TECHNOLOGY USING MULTISTAGENOISE SHAPING" IEEE JOURNAL OF SOLID-STATE CIRCUITS, Bd. 24, Nr. 4, 1. August 1989, Seiten 969-975, XP000066225**
• **UCHIMURA K ET AL: "OVERSAMPLING A-TO-D AND D-TO-A CONVERTERS WITH MULTISTAGE NOISE SHAPING MODULATORS" IEEE TRANSACTIONS ON ACOUSTICS, SPEECH AND SIGNAL PROCESSING, Bd. 36, Nr. 12, Dezember 1988, Seiten 1899-1905, XP000054326**

EP 0 731 566 B1

**Beschreibung**

Die Erfindung betrifft eine Schaltungsanordnung zur Umsetzung eines 1-Bit-Digitalsignals mit gegebener Abtastfrequenz in ein Analogsignal enthaltend eine analoge Multipliziereinrichtung, an deren einen Eingang das Digitalsignal und an deren anderen Eingang ein Referenzsignal angelegt sind.

Derartige Schaltungsanordnungen werden beispielsweise bei der Rückführung des digitalen Ausgangssignals eines Analog-Digital-Umsetzer nach dem Sigma-Delta-Prinzip in dessen analogen Eingangskreis verwendet. Eine Schaltungsanordnung der eingangs genannten Art sowie deren Anwendung bei einem Analog-Digital-Umsetzer nach dem Sigma-Delta-Prinzip ist bei T.Hayashi et al, A Multistage Delta-Sigma Modulator without Double Integration Loop, 1986 IEEE International Solid-State Circuits Conference, S. 182 u. 183 beschrieben. Ein analoges Eingangssignal wird mit dieser Art von Wandlern in ein digitales 1-Bit-Ausgangssignal umgewandelt. Das dabei enstehende große Quantisierungsrauschen wird durch die sogenannte "Noiseshapingfunktion" aus dem Basisband zu höheren Frequenzen hin verschoben und anschließend mittels digitaler Filter gedämpft. Der entsprechende Digital-Analog-Umsetzer funktioniert im wesentlichen nach den gleichen Grundsätzen, jedoch nur in umgekehrter Reihenfolge. Das bedeutet, daß zunächst ein digitales Noiseshaping vorgenommen wird, dem die Digital-Analog-Umsetzung und daran anschließend eine analoge Filterung folgen.

Die Noiseshapingfunktion der Sigma-Delta-Umsetzer hat nicht nur die Eigenschaft das Quantisierungsrauschen zu höheren Frequenzen hin zu verschieben, sondern neigt auch zur Bildung von Grenzzyklen bei Gleichspannungen am Eingang. Diese sind je nach Ordnung der Noiseshapingfunktion mehr oder weniger ausgeprägt und treten bei kleinen Gleichspannungen im Bereich der halben Abtastfrequenz auf. Ein solcher Fall tritt beispielsweise dann auf, wenn kein Signal am Eingang anliegt, jedoch ein Gleichspannungsanteil durch interne Offset-Spannungen der Analogkomponenten, wie beispielsweise Verstärker, Filter und Wandler, entstehen. Je größer die Offsetspannung ist, umso weiter sind die Grenzzyklen von der halben Abtastfrequenz entfernt. Grenzzyklen stören im Idealfall nicht, da sie außerhalb des Basisbandes liegen und durch die anschließende Filterung beseitigt werden.

Die bei sämtlichen Sigma-Delta-Umsetzern notwendige 1-Bit-Digital-Analag-Umsetzung entspricht einer Mulitplikation eines digitalen 1-Bit-Pulsdichtesignals mit einem analogen Referenzsignal. Da die Umsetzer meistens in Kombination mit weiteren digitalen Schaltungseinheiten, beispielsweise einem Signalprozessor, betrieben werden und meist sogar auf ein und dem selben Chip integriert sein können, gelangen sehr leicht deren Taktimpulse als Störer in das Referenzsignal. Häufig entspricht dabei die Frequenz des Störsignals der Hälfte der Abtastfrequenz.

Durch die Multiplikation des digitalen 1-Bit-Pulsdichtesignals mit einem durch einen Eingangs-Offset hervorgerufenen Grenzzyklus mit einer Frequenz von beispielsweise der halben Abtastfrequenz abzüglich eines niederfrequenten Signals von beispielsweise 2 KHz und einem durch ein Störsignal mit halber Abtastfrequenz überlagerten Referenzsignal kommt es zu einer Faltung des Grenzzyklus in das Basisband, wobei das durch den Offset hervorgerufene niederfrequente Signal hörbar wird.

Der Pegel solcher Grenzzyklen ist von der Größe der Störeinkopplung auf das Referenzsignal abhängig und kann als diskrete Linie in den Geräuschspektrum auftreten. Neben solchen Grenzzyklen wird außerdem das Rauschspektrum um die halbe Abtastfrequenz in das Basisband gefaltet und vermindert somit zusätzlich den Signal-Rauschabstand.

Aufgabe der Erfindung ist es, eine Schaltungsanordnung der eingangs genannten Art anzugeben, bei der diese Nachteile nicht auftreten.

Die Aufgabe wird bei einer gattungsgemäßen Schaltungsanordnung durch die kennzeichnenden Merkmale des Patentanspruches 1 gelöst. Ausgestaltungen und Weiterbildungen des Erfindungsgedankens sind Gegenstand von Unteransprüchen.

Vorteil der Erfindung ist es, daß mit geringem zusätzlichem schaltungstechnischen Aufwand eine weitgehende Störunterdrückung erzielt wird.

Die Erfindung wird nachfolgend anhand der in den Figuren der Zeichnung dargestellten Ausführungsbeispiele näher erläutert.
Es zeigt:

Figur 1    eine prinzipielle Ausführungsform einer erfindungsgemäßen Schaltungsanordnung in einem Blockdiagramm,

Figur 2    das Schaltbild einer Ausführungsform der erfindungsgemäßen Schaltungsanordnung in Switched-Capacitor-Technik,

Figur 3    die Anwendung einer erfindungsgemäßen Schaltungsanordnung bei einem Digital-Analog-Umsetzer nach dem Sigma-Delta-Prinzip und

Figur 4    eine Anwendung der erfindungsgemäßen Schaltungsanordnung bei einem Analog-Digital-Umsetzer nach dem Sigma-Delta-Prinzip.

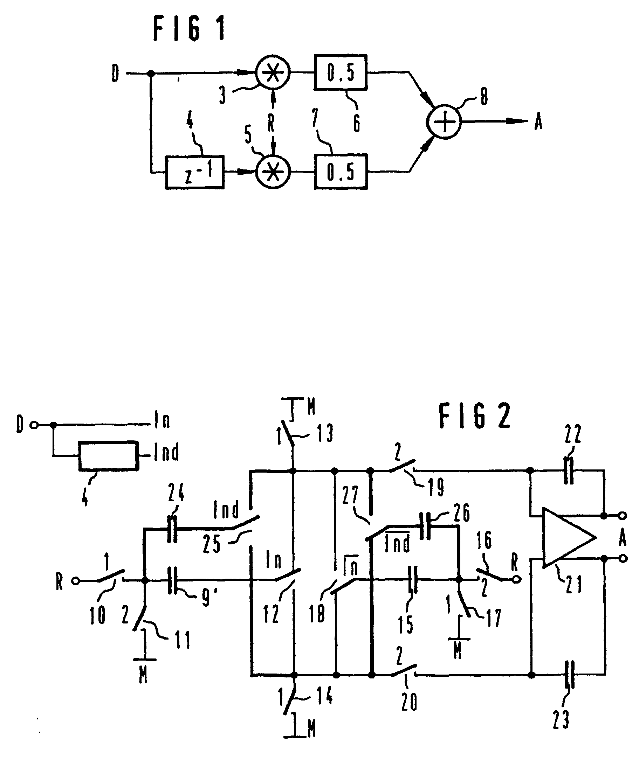

Bei dem Ausführungsbeispiel nach Figur 1 wird ein digitales 1-Bit-Pulsdichtesignal an einen Eingang einer Multiplizireinrichtung 3 sowie an den Eingang einer Verzögerungseinrichtung 4 angelegt. Die Verzögerungseinrichtung 4 verzögert das digitale Signal D um eine Abtasttaktperiode. Der Ausgang der Verzögerungseinrichtung 4 ist auf einen Eingang einer weiteren Multiplizireinrichtung 5 geführt. Die jeweils anderen Eingänge der beiden Multiplizireinrichtungen 3 und 5 sind jeweils mit einem Referenzsignal R belegt. Den Multipliziereinrichtungen 3 und 5 ist jeweils eine Dämpfungseinrichtung 6 bzw. 7 nachgeschaltet, die jeweils eine Dämpfung um die Hälfte bewirken. Die Dämpfungen beider Dämpfungseinrichtungen 6 und 7 können aber auch beliebige, vom jeweiligen Anwendungsfall abhängige Werte annehmen. Bevorzugt werden aber gleiche Dämpfungswerte gewählt. Durch Änderung der Dämpfungswerte lassen sich unterschiedliche Amplituden- und Frequenzgänge erzielen. Die Ausgänge der beiden Dämpfungseinrichtungen 6 und 7 sind auf jeweils einen Eingang einer analogen Addiereinrichtung 8 geführt, an deren Ausgang ein dem digitalen Signal D entsprechendes analoges Signal A bereitsteht.

Bei dem Ausführungsbeispiel nach Figur 2 sind die beiden Multipliziereinrichtungen, die Dämpfungseinrichtungen sowie die Addiereinrichtung durch ein Switched-Capacitor-Netzwerk gegeben. Dieses Switched-Capacitor-Netzwerk weist einen Kondensator 9 auf, dessen einer Anschluß über einen Schalter 10 auf das Referenzsignal R und über einen Schalter 11 auf ein Bezugspotential M aufschaltbar ist. Der andere Anschluß des Kondensators 9 ist über einen Umschalter 12 entweder auf den einen Anschluß eines Schalters 13 oder auf einen Anschluß eines Schalters 14 aufschaltbar. Die anderen Anschlüsse der Schalter 13 und 14 sind jeweils mit dem Bezugspotential M verbunden. Ein Anschluß eines Kondensators 15 ist über einen Schalter 16 auf das Referenzsignal R und über einen Schalter 17 auf das Bezugspotential M aufschaltbar. Der andere Anschluß des Kondensators 15 ist über einen Umschalter 18 entweder auf den einen Anschluß des Schalters 13 oder auf den einen Anschluß des Schalters 14 aufschaltbar. Der eine Anschluß des Schalters 13 und der eine Anschluß des Schalters 14 sind über jeweils einen Schalter 19 bzw. 20 auf jeweils einen Eingang eines Intergrierers aufschaltbar. Der Integrierer besteht seinerseits aus einem symmetrischen Operationsverstärker 21 der zwischen invertierendem Eingang und nichtinvertierten Ausgang sowie zwischen nichtinvertierendem Eingang und invertiertem Ausgang durch jeweils einem Kondensator 22 bzw. 23 rückgekoppelt ist. An den symmetrischen Ausgängen eines Operationsverstärkers 21 steht das Analogsignal A bereit. In dieser Konfiguration ist die Multipliziereinrichtung 3 sowie die Dämpfungseinrichtung 6 nach Figur 1 realisiert.

Zur Realisierung der Multipliziereinrichtung 5 und der Dämpfungseinrichtung 7 ist zusätzlich ein Kondensator 24 vorgesehen, dessen einer Anschluß mit dem einen Anschluß des Kondensators 9 verbunden ist und dessen anderer Anschluß über einen Umschalter 25 entweder auf den einen Anschluß des Schalters 13 oder den einen Anschluß des Schalters 14 aufschaltbar ist. Weiterhin ist der eine Anschluß eines Kondensators 26 mit dem einen Anschluß des Kondensators 15 verbunden. Der andere Anschluß des Kondensators 26 ist über einen Umschalter 27 entweder auf den einen Anschluß des Schalters 13 oder den einen Anschluß des Schalters 14 aufschaltbar.

Zur Steuerung der einzelnen Schalter finden zum einen zwei Schaltphasen 1 und 2 eines Taktsignales oder die beiden Schaltphasen In und $\overline{\text{In}}$ des Digitalsignals D oder die beiden Schaltphasen Ind und $\overline{\text{Ind}}$ des verzögerten Digitalsignals D Verwendung. Dabei werden die Schalter 10, 13, 14 und 17 durch die Schaltphase 1 und die Schalter 11, 16, 19 und 20 durch die Schaltphase 2 durchgeschaltet. Die Umschalter 12 und 18 werden durch die Schaltphase In bzw. In auf den einen Anschluß des Schalters 14 bzw. auf den einen Anschluß des Schalters 13 aufgeschaltet. Die Umschalter 25 und 27 werden dementsprechend durch die Schaltphase Ind bzw. $\overline{\text{Ind}}$ auf den einen Anschluß des Schalters 14 bzw. den einen Anschluß des Schalters 13 aufgeschaltet.

Die Addition der beiden unterschiedliche multiplizierten Signale erfolgt zum einen an dem einen Anschluß des Schalters 13 und zum anderen an dem einen Anschluß des Schalters 14. Aufgrund der Symmetrie sind die Kondensatoren 22 und 23 untereinander und die Kondensatoren 9 und 15 untereinander jeweils gleich. Ebenso sind auch die Kondensatoren 24 und 26 untereinander gleich.Das Verhältnis der Dämpfungseinrichtungen 6 und 7 wird dabei mittels der Kapazitäten der Kondensatoren 24, 26 im Verhältnis zu den Kondensatoren 9 und 15 eingestellt. Wählt man einen Dämpfungswert von 0,5 jeweils, so halbiert sich die Kapazität der Kondensatoren 9 und 15 gegenüber der Verwendung nur einer einzigen Multipliziereinrichtung 3. Da in dem Fall auch die Kapazität der Kondensatoren 24 und 26 gleich der Kapazität der Kondensatoren 9 und 15 ist, also wiederum die Hälfte, bleibt die insgesamt benötigte Kondensatorfläche gleich. Durch den Dämpfungsfaktor 0,5 wird also eine Halbierung der Kondensatorwerte erreicht, wodurch sich bei einer Ausführung der erfindungsgemäßen Schaltungsanordnung in integrierter Schaltungstechnik der Flächenzuwachs des integrierten Schaltkreises lediglich auf die zwei zusätzlichen Umschalter 25 und 27 sowie die Verzögerungseinrichtung 4 beschränkt.

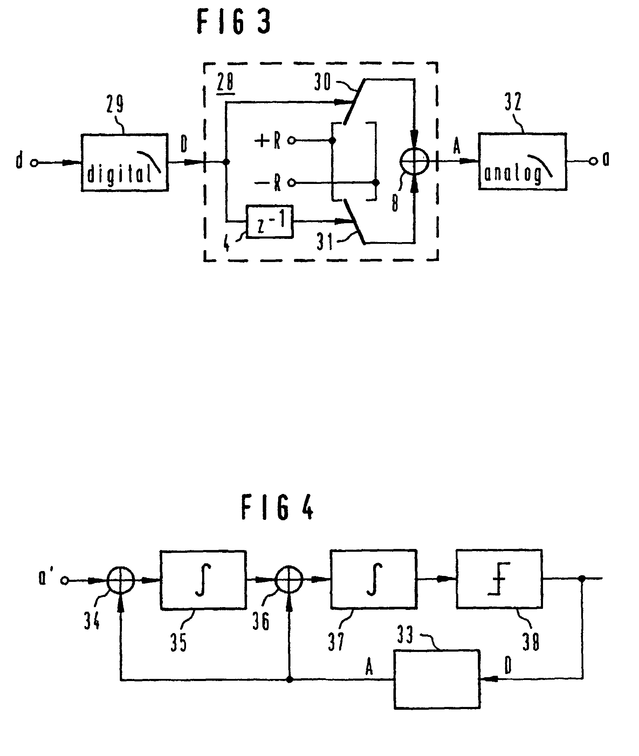

Die Anwendung einer erfindungsgemäßen Schaltungsanordnung 28 bei einer Digital-Analog-Umsetzeinrichtung nach dem Sigma-Delta-Prinzip ist in Figur 3 dargestellt. Ein umzusetzendes digitales Signal d wird dabei einem digitalen Filter 29 zugeführt, mittels dessen das Noiseshaping des Signals D durchgeführt wird. Am Ausgang des digitalen Filters 29 steht das der Schaltungsanordnung 28 zugeführte Digitalsignal D bereit. Gegenüber der Ausführungsform der erfindungsgemäßen Schaltungsanordnung nach Figur 1 ist die Ausführungsform nach Figur 3 dahingehend abgeändert, daß beide Multiplikationseinrichtungen jeweils einen durch das Digitalsignal D gesteuerten Schalter 30 bzw. 31 aufweisen, die jeweils in einem Schaltzustand ein positives Referenzsignal +R und im anderen Schaltzustand ein negatives Referenzsignal -R zum jeweiligen Eingang der Addiereinrichtung 8 durchschaltet. Dabei wird der Schalter 31 durch das mittels der Verzögerungseinrichtung 4 verzögerten Digitalsignal D angesteuert. Bei dieser Ausführungsform werden die Dämpfungen der Dämpfungseinrichtungen 6 und 7 durch entsprechende Wahl der beiden Referenzspannungen +R und -R ersetzt, wobei in diesem Fall die beiden Dämpfungsfaktoren immer gleich sind. Das am Ausgang der Addiereinrichtung 8 bereitstehende Analogsignal A wird einem analogen Filter 32 zur Bandbegrenzung zugeführt. An dessen Ausgang steht somit ein analoges Signal a zur Verfügung, das aus dem digitalen Signal d hervorgeht.

Eine weitere bevorzugte Anwendung der erfindungsgemäßen Schaltungsanordnung 33 ist gemäß Figur 4 bei einer Analog-Digital-Umsetzeinrichtung nach dem Sigma-Delta-Prinzip. Die Schaltungsanordnung 33 ist beispielsweise entsprechend der in Figur 2 gezeigten Ausführungsform aufgebaut. Ein zu wandelndes analoges Signal a' wird beispielsweise bei einem Sigma-Delta-Umsetzer 2. Ordnung an den Eingang eines Addierers 34 gelegt, dessen anderer Eingang mit dem am Ausgang der Schaltungsanordnung 33 bereitstehenden Analogsignal A beaufschlagt ist. Dem Ausgang des Addierers 34 ist ein erster Integrierer 35 nachgeschaltet, dessen Ausgang wiederum auf einen Eingang eines Addierers 36 geführt ist. Der andere Eingang des Addierers 36 ist ebenfalls mit dem Analog-Signal A beaufschlagt. Dem Addierer 36 ist ein zweiter Integrator 37 nachgeschaltet, dem ein Komparator 38 folgt. Der Komparator 38 gibt das Digitalsignal D ab, das zum einen der erfindungsgemäßen Schaltungsanordnung 33 zugeführt wird und zum anderen zur weiteren Verarbeitung beispielsweise mittels eines digitalen Filters zur Verfügung steht.

Die Funktionsweise der erfindungsgemäßen Schaltungsanordnung beruht darauf, daß eine Kerbfilterfunktion erzeugt wird, deren größte Dämpfung bei der halben Abtastfrequenz liegt. Grenzzyklen um die halbe Abtastfrequenz und Störanteile bei der halben Abtastfrequenz im Referenzsignal werden dadurch herausgefiltert und eine Faltung der Grenzzyklen als auch des Rauschens in das Basisband vermieden.

**Patentansprüche**

1. Schaltungsanordnung zur Umsetzung eines 1-Bit-Digital-Signals mit gegebener Abtastfrequenz in ein Analogsignal (A) enthaltend eine Multipliziereinrichtung (3), an deren einen Eingang das Digitalsignal (D) und an deren anderen Eingang ein Referenzsignal (R) angelegt sind,
**gekennzeichnet durch**
eine Verzögerungseinrichtung (4), an die das Digitalsignal (D) angelegt ist und die das Digitalsignal (D) um eine Periode der Abtastfrequenz verzögert,
**durch** eine weitere Multipliziereinrichtung (5), deren einer Eingang an den Ausgang der Verzögerungseinrichtung (4) angeschlossen ist und an deren anderen Eingang das Referenzsignal (R) angelegt ist, sowie
**durch** eine Addiereinrichtung (8), deren Eingänge jeweils mit den Ausgängen der beiden Multipliziereinrichtungen (3, 5) verbunden sind und an deren Ausgang das Analogsignal (A) bereitsteht.

2. Schaltungsanordnung nach Anspruch 1,
**dadurch gekennzeichnet, daß** zwischen die Ausgänge der beiden Multipliziereinrichtungen (3, 5) und die Eingänge der Addiereinrichtung (8) jeweils eine Dämpfungseinrichtung (6, 7) mit jeweils einem bestimmten Dämpfungsfaktor geschaltet ist.

3. Schaltungsanordnung nach Anspruch 1 oder 2,
**dadurch gekennzeichnet, daß**
mindestens eine der Multiplikationseinrichtungen (3, 5) einen durch das Digitalsignal (D) gesteuerten Schalter (30, 31) aufweist, der in einem Schaltzustand das Referenzsignal (+R) und im anderen Schaltzustand das invertierte Referenzsignal (-R) zum Ausgang durchschaltet.

4. Schaltungsanordnung nach Anspruch 1,
**dadurch gekennzeichnet,**
**daß** die beiden Multipliziereinrichtungen (3, 5) und die Addiereinrichtung (8) gebildet werden,
durch einen ersten Kondensator (9), dessen einer Anschluß über einen ersten Schalter (10) auf das Referenzsignal (R) und über einen zweiten Schalter (11) auf ein Bezugspotential (M) aufschaltbar ist und dessen anderer Anschluß über einen dritten Schalter (12) auf einen Anschluß eines vierten Schalters (13) oder auf einen Anschluß eines fünften Schalters (14) aufschaltbar ist, wobei die anderen Anschlüsse von viertem und fünftem Schalter (13, 14) mit dem Bezugspotential (M) verbunden sind,
durch einen zweiten Kondensator (15), dessen einer Anschluß über einen sechsten Schalter (16) auf das Referenzsignal (R) und über einen siebten Schalter (17) auf das Bezugspotential (M) aufschaltbar ist und dessen anderer Anschluß über einen achten Schalter (18) auf den einen Anschluß des vierten Schalters (13) oder den einen Anschluß des fünften Schalters (14) aufschaltbar ist,
durch einen dritten Kondensator (24), dessen einer Anschluß mit dem einen Anschluß des ersten Kondensators (9) verbunden ist und dessen anderer Anschluß über einen neuten Schalter (25) auf den einen Anschluß des vierten Schalters (13) oder auf den einen Anschluß des fünften Schalters (14) aufschaltbar ist,
durch einen vierten Kondensator (26), dessen einer Anschluß mit dem einen Anschluß des zweiten Kondensators (15) verbunden ist und dessen anderer Anschluß über einen zehnten Schalter (27) auf den einen Anschluß des vierten Schalters (13) oder auf den einen Anschluß des fünften Schalters (14) aufschaltbar ist und

durch einen Integrierer (21, 22, 23) mit symmetrischen Eingängen, dessen einer Eingang über einen elften Schalter (19) auf den einen Anschluß des vierten Schalters (13) und dessen anderer Eingang über einen zwölften Schalter (20) auf den einen Anschluß des fünften Schalters (14) aufschaltbar ist und der am Ausgang das Analogsignal (A) abgibt, **daß** erster, vierter, fünfter und siebter Schalter (10, 13, 14, 17) durch eine erste Schaltphase (1) eines Taktsignals und zweiter, sechster, elfter und zwölfter Schalter (11, 16, 19, 20) durch eine zur ersten Schaltphase (1) inversen zweiten Schaltphase (2) des Taktsignals durchgeschaltet werden und **daß** der dritte Schalter (12) durch das Digitalsignal (D), der achte Schalter (18) durch das invertierte Digitalsignal (D), der neunte Schalter (25) durch das mittels der Verzögerungseinrichtung (4) verzögerte Digitalsignal (D) und der zehnte Schalter (27) durch das invertierte, verzögerte Digitalsignal (D) umgeschaltet wird.

5. Verwendung der Schaltungsanordnung nach einem der Ansprüche 1 bis 4 bei einer Digital-Analog-Umsetzeinrichtung nach dem Sigma-Delta-Prinzip.

6. Verwendung der Schaltungsanordnung nach einem der Ansprüche 1 bis 4 bei einer Analog-Digital-Umsetzeinrichtung nach dem Sigma-Delta-Prinzip.

**Claims**

1. Circuit arrangement for converting a 1-bit digital signal of given sampling frequency into an analogue signal (A), containing a multiplication device (3) to whose one input the digital signal (D) is applied and to whose other input a reference signal (R) is applied, **characterized by** a delay device (4) to which the digital signal (D) is applied and which delays the digital signal (D) by one period of the sampling frequency, by a further multiplication device (5), whose one input is connected to the output of the delay device (4) and to whose other input the reference signal (R) is applied, and also by an adding device (8) whose inputs are respectively connected to the outputs of the two multiplication devices (3, 5) and whose output provides the analogue signal (A).

2. Circuit arrangement according to Claim 1, **characterized in that** a respective attenuation device (6, 7) having a respective particular attenuation factor is connected between the outputs of the two multiplication devices (3, 5) and the inputs of the adding device (8).

3. Circuit arrangement according to Claim 1 or 2, **characterized in that** at least one of the multiplication devices (3, 5) has a switch (30, 31) which is controlled by the digital signal (D) and, in one switching state, connects the reference signal (+R) to the output, and, in the other switching state, connects the inverted reference signal (-R) to the output.

4. Circuit arrangement according to Claim 1, **characterized in that** the two multiplication devices (3, 5) and the adding device (8) are formed by a first capacitor (9), whose one connection can be connected to the reference signal (R) by means of a first switch (10) and to a reference-ground potential (M) by means of a second switch (11) and whose other connection can be connected to one connection of a fourth switch (13) or to one connection of a fifth switch (14) by means of a third switch (12), the other connections of the fourth and fifth switches (13, 14) being connected to the reference-ground potential (M), by a second capacitor (15), whose one connection can be connected to the reference signal (R) by means of a sixth switch (16) and to the reference-ground potential (M) by means of a seventh switch (17) and whose other connection can be connected to one connection of the fourth switch (13) or to one connection of the fifth switch (14) by means of an eighth switch (18), by a third capacitor (24), whose one connection is connected to one connection of the first capacitor (9) and whose other connection can be connected to one connection of the fourth switch (13) or to one connection of the fifth switch (14) by means of a ninth switch (25), by a fourth capacitor (26), whose one connection is connected to one connection of the second capacitor (15) and whose other connection can be connected to one connection of the fourth switch (13) or to one connection of the fifth switch (14) by means of a tenth switch (27), and by an integrator (21, 22, 23) having symmetrical inputs, whose one input can be connected to one connection of the fourth switch (13) by means of an eleventh switch (19) and whose other input can be connected to one connection of a fifth switch (14) by means of a twelfth switch (20) and whose output outputs the analogue signal (A), the first, fourth, fifth and seventh switches (10, 13, 14, 17) are turned on by a first switching phase (1) of a clock signal, and the second, sixth, eleventh and twelfth switches (11, 16, 19, 20) are turned on by a second switching phase (2) of the clock signal, which is the inverse of the first switching phase (1), and the third switch (12) is changed over by the digital signal (D), the eighth switch (18) is changed over by the inverted digital signal (D), the ninth switch (25) is changed over by the digital signal (D) delayed by means of the delay device (4), and the tenth switch (27) is changed over by the inverted, delayed digital signal (D).

5. Use of the circuit arrangement according to one of Claims 1 to 4 in a digital-analogue conversion device based on the sigma-delta principle.

6. Use of the circuit arrangement according to one of Claims 1 to 4 in an analogue-digital conversion device based on the sigma-delta principle.

**Revendications**

1. Montage pour la conversion d'un signal numérique à 1 bit à fréquence d'échantillonnage donnée en un signal analogique (A), comprenant un dispositif de multiplication (3), sur l'une des entrées duquel est appliqué le signal numérique (D) et sur l'autre des entrées duquel est appliqué un signal de référence (R), **caractérisé par** un dispositif de temporisation (4) auquel est appliqué le signal numérique (D) et qui retarde le signal numérique (D) d'une période de la fréquence d'échantillonnage, par un autre dispositif de multiplication (5) dont l'une des entrées est reliée à la sortie du dispositif de temporisation (4) et sur l'autre entrée duquel est appliqué le signal de référence (R), ainsi que par un dispositif d'addition (8) dont les entrées sont respectivement reliées aux sorties des deux dispositifs de multiplication (3, 5) et à la sortie desquels le signal analogique (A) est disponible.

2. Montage selon la revendication 1, **caractérisé en ce qu'**entre les sorties des deux dispositifs de multiplication (3, 5) et les entrées du dispositif d'addition (8) est couplé respectivement un dispositif d'amortissement (6, 7) avec respectivement un facteur d'amortissement.

3. Montage selon la revendication 1 ou 2, **caractérisé en ce qu'**au moins l'un des dispositifs de multiplication (3, 5) présente un contact (30, 31) commandé par le signal numérique (D), qui communique à la sortie dans un état de couplage le signal de référence (+R) et dans l'autre état de couplage le signal de référence inversé (-R).

4. Montage selon la revendication 1, **caractérisé en ce que** les deux dispositifs de multiplication (3, 5) et le dispositif d'addition (8) sont constitués

par un premier condensateur (9) dont l'une des connexions peut être couplée par un premier contact (10) sur le signal de référence (R) et par un deuxième contact (11) sur un potentiel de référence (M), et dont l'autre connexion peut être couplée par un troisième contact (12) sur une connexion d'un quatrième contact (13) ou sur une connexion d'un cinquième contact (14), les autres connexions des quatrième et cinquième contacts étant reliées au potentiel de référence (M),

par un deuxième condensateur (15) dont l'une des connexions peut être couplée par un sixième contact (16) sur le signal de référence (R) et par un septième contact (17) sur le potentiel de référence (M), et dont l'autre connexion peut être couplée par un huitième contact (18) sur l'une des connexions du quatrième contact (13) ou sur l'une des connexions du cinquième contact (14),

par un troisième condensateur (24) dont l'une des connexions est reliée à l'une des connexions du premier condensateur (9), et dont l'autre connexion peut être couplée par un neuvième contact (25) sur l'une des connexions du quatrième contact (13) ou sur l'une des connexions du cinquième contact (14),

par un quatrième condensateur (26) dont l'une des connexions est reliée à l'une des connexions du deuxième condensateur (15), et dont l'autre connexion peut être couplée par un dixième contact (27) sur l'une des connexions du quatrième contact (13) ou sur l'une des connexions du cinquième contact (14), et

par un intégrateur (21, 22, 23) ayant des entrées symétriques dont l'une des entrées est couplée par un onzième contact (19) sur l'une des connexions du quatrième contact (13), et dont l'autre entrée est couplée par un douzième contact (20) sur l'une des connexions du cinquième contact (14), et qui émet à la sortie le signal analogique (A),

**en ce que** les premier, le quatrième, le cinquième et le septième contacts (10, 13, 14, 17) sont rendus passants par une première phase de couplage (1) d'un signal de synchronisation, et les deuxième, sixième, onzième et douzième contacts (11, 16, 19, 20) sont reliés par une deuxième phase de couplage (2) inversée par rapport à la première phase de couplage (1), et

**en ce que** le troisième contact (12) est commuté par le signal numérique (D), le huitième contact (18) par le signal numérique inversé (D), le neuvième contact (25) par le signal numérique (D) retardé à l'aide du dispositif de temporisation (4) et le dixième contact (27) par le signal numérique (D) inversé retardé.

5. Utilisation du montage selon l'une des revendications 1 à 4 dans un dispositif de conversion numérique-analogique selon le principe de sigma-delta.

6. Utilisation du montage selon l'une des revendications 1 à 4 dans un dispositif de conversion analogique-numérique selon le principe de sigma-delta.

# FIG 1

# FIG 2

8

# FIG 3

# FIG 4